Europäisches Patentamt

(19) European Patent Office

Office européen des brevets

(11) Publication number: **0 072 414**
**B1**

## (12) EUROPEAN PATENT SPECIFICATION

(45) Date of publication of patent specification: **13.01.88**

(51) Int. Cl.⁴: **G 11 C 11/34, H 01 L 27/10**

(21) Application number: **82105776.7**

(22) Date of filing: **29.06.82**

(54) **Dynamic semiconductor memory cell.**

(30) Priority: **14.08.81 US 293413**

(43) Date of publication of application:
**23.02.83 Bulletin 83/08**

(45) Publication of the grant of the patent:
**13.01.88 Bulletin 88/02**

(84) Designated Contracting States:
**DE FR GB**

(56) References cited:
**EP-A-0 030 856**
**DE-A-2 333 400**
**IBM TECHNICAL DISCLOSURE BULLETIN, vol.
10, no. 4, September 1967, pages 500-501, New
York, US; J.B. GILLET: "Unijunction transistor
storage cell"**
**SOLID STATE ELECTRONICS, vol. 18, 1975,
pages 715-716, Pergamon Press, GB; J.R.
HAUSER et al.: "Minority carrier reflecting
properties of semiconductor high-low
junctions"**

(73) Proprietor: **International Business Machines
Corporation
Old Orchard Road
Armonk, N.Y. 10504 (US)**

(72) Inventor: **Bhatia, Harsaran Singh
41 Tor Road
Wappingers Falls, N.Y. 12590 (US)**
Inventor: **Eardley, David Barry
Stissing Road
Stanfordville, N.Y. 12582 (US)**
Inventor: **Gaur, Santosh Prasad
23C Carnaby Street
Wappingers Falls, N.Y. 12590 (US)**

(74) Representative: **Gaugel, Heinz, Dipl.-Ing.
Schönaicher Strasse 220
D-7030 Böblingen (DE)**

Courier Press, Leamington Spa, England.

## Description

This invention relates to a dynamic storage device utilizing the concept of trapping minority carriers for data storage.

Developmental work in semiconductor memories and in particular to binary random access memories (RAM) has resulted in the number of bits of storage per chip increasing to approximately 64000. At the same time, the cost per bit, due to increased processing efficiencies, has dramatically decreased. The computer industry has a standing requirement for increased storage capacity by the formation of small, reliable memory cells formed on a single chip. The formation of a large number of memory cells on a chip yields economies, in terms of cost per bit, so long as the processing steps allow for acceptable yield rates.

Individual chips interconnect to form a memory array. Since a significant portion of the total cost in the production of semiconductor chips is in the steps of interconnecting, packaging, testing, and the like, an increase in memory cells count per chip decreases a total number of chips which must be handled to form the memory array. Accordingly, a packing criteria in the definition of improved semiconductor memories is to achieve greater packing densities while at the same time maintaining the process as simple as possible.

Within the prior art, a host of different techniques of forming descrete cells for semiconductor memories are known. Reference is made to U.S. Patent 4 164 751 which summarizes a number of methods of making memory cells used in the construction of semiconductor memory chips.

A second requirement, mitigating against high packing density, is that each cell have a charge capacity per unit area which is at an acceptable level so that the charge stored therein is distinguishable from noise in the memory. As packing density increases, the number of cells per chip increases and therefore the size of each cell for a given chip area decreases. Accordingly, the amount of charge that can be stored in an individual cell decreases, reaching a point where the amount of stored charged is unacceptably low. A balancing packing density vs. signal strength is therefore a serious consideration.

U.S. Patent 3 852 800 describes a memory storage cell utilizing the inherent metal-insulator-semiconductor capacitance and the P-N junction capacitance at the source node of a field effect transistor. In order to enhance charge storage, an extended portion of the source diffusion in combination with overlying thin oxide and metal layers forms a capacitor. Accordingly, the '800 patent utilizes a single IGFET with the binary data represented in the form of a stored charge arranged in a matrix of memory cells to define a random access memory.

U.S. Patent 4 122 543 shows a variation of the MIS structure shown in the '800 patent by utilizing a second storage state having an MIIS element whose electric charge is controlled by the width of the channel formed between two depletion zones in a substrate which forms a first storage state. The MIIS structure is formed by a layer of metal covered by two layers of an insulator, the second being very thin and finally by semiconductor layer. The MIIS structure in the '543 patent acts when a positive voltage is applied to the metal layer with respect to the semiconductor layer. Electrons from the semiconductor pass through the thinnest insulating layer by tunnel effects and are trapped at the interface between the two interface layers. Alternatively, the electrons can be trapped in an ion implant area with the charge therein retained for a long period of time, in the order of one year. Erasure of the charge is obtained by applying a voltage in the opposite direction.

U.S Patent 4 164 751 also relates to a memory system integrated in a semiconductor substrate having an N+ region on a first surface of a semiconductor substrate forming a bit line and transistor source. A storage region is defined in the same surface spaced from the N+ region and comprises an N− type implant in the substrate near the first surface together with a P type implant in the substrate beneath the N type implant. An insulating layer is formed with a storage gate region and a transfer gate region formed overlying the insulating layer.

In each memory cell, the charge is stored in both an oxide capacitor and in a depletion capacitor. The oxide capacitor is defined by the storage gate and an N type implant separated by an insulating layer. The depletion capacitor is formed by a storage region defined by two ion implants near the surface of the memory cell.

Accordingly, while a variety of prior art devices utilize charge storage techniques, in MIS capacitors, P-N junction capacitance and depletion layer capacitance, all are categorized by a requirement of multiple, difficult processing steps. Hence, there still exists a requirement for a memory cell achieving high packing density yet manufactured by a relatively simple process. Power dissipation also remains a problem particularly in IGFET devices. While high packing densities are achieved, power dissipation in such devices remains a consideration. This shortcoming restricts overall array size tending to restrict overall memory size. Moreover, special measures must be taken for power conditioning.

Moreover, prior art dynamic memories require thin film dielectrics that are difficult to manufacture. In the case of charge storage on P+/N+ junction capacitance, leakage due to tunneling requires the data to be refreshed more frequently. A large number of masks are generally required in the formation of those devices and while the processing steps per se are well established in the art, cost and yield considerations remain as areas requiring improved process steps.

The invention as claimed is intended to remedy these drawbacks. It solves the problem of how to design a memory cell having higher packing densities in dynamic memory arrays, having low power dissipation, and eliminating the requirement of external gating devices for each memory cell in a memory array.

Another object of this invention is to define a dynamic memory device utilizing processing capitable with bi-polar device processing but utilizing a reduced number of masks.

An important feature of this invention is the incorporation of the gating member as an integral element of the device. A low barrier Schottky diode is formed at the drain region to perform the gating function and thereby eliminate a potential external circuit element.

In accordance with the present invention as defined in Claim 1, a single device dynamic semiconductor memory is formed having a P-type conductivity injector region with high-low-high junctions of N-type conductivity disposed below the injector region. Those junctions trap injected minority charges which are detected by sensing the current flow from a source region to a drain region which are located on opposite sides of the injector region. The source and injection regions utilize ohmic contact while the low barrier Schottky contact is made to the drain region. In order to provide separation between the depletion region of the Schottky contact in the injector region, a heavily doped N region is provided.

This invention will be explained in greater detail by referring to the attached drawings and the description of the preferred embodiment which follows.

Fig. 1 is a schematic side view showing a single cell of the bipolar dynamic memory in accordance with this invention;

Fig. 2 is an equivalent circuit of the device shown in Fig. 1;

Fig. 3 is a circuit diagram of a 2 × 2 memory array; and

Fig. 4 is a timing diagram showing the operation of the device.

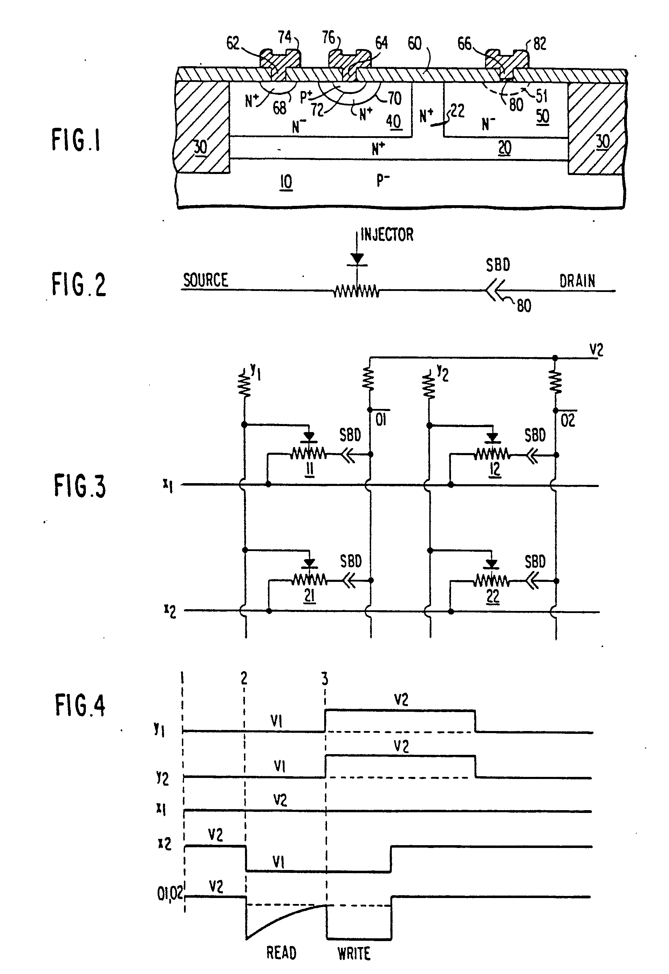

Referring now to Figure 1, a cross section view of one cell of the dynamic memory array in accordance with this invention is depicted.

The substrate, typically a silicon of the P-type 10 is formed having a resistivity in the range of 10—20 Ω-cm. On top of the substrate 10, a blanket semiconductor 20 of a N+ type is formed, and an epitaxial N⁻ layer grown over this. This layer is subsequently divided into regions 40 and 50. The N+ type region 20 is bounded on both sides of the cells by an oxide filled trench 30 to achieve deep dielectric isolation of the cells. Deep dielectric isolation is achieved by techniques known in the art.

A thin oxide layer, 400—500 Å (1 Å = 10⁻¹⁰ m) is thermally grown over the N⁻ epitaxial layer. A photoresist mask is used to open the area corresponding to region 22. By ion implantation of phosphorous the N+ region 22 is formed. The photoresist is then removed and the $SiO_2$ layer 60 is deposited. Typical thickness of the layer 60 is in the range of 3000 Å. The region 22 separates the N⁻ epitaxial region into two sections 40 and 50.

The $SiO_2$ oxide layer 60 formed on the top surface has openings 62, 64, and 66 to allow contact to the N⁻ epi. Opening 62 defines the source region having an N+ implantation layer 68 beneath the opening. At the injector region, beneath opening 64, an N+ region 70 surrounds a P+ implant 72. Metal lines 74, 76 are evaporated above the source and injector regions. The N+ regions may be phosphorous or arsenic implants, while the P+ region is a boron implant.

The present invention departs from the above-referenced copending application by the use of the N+ separating or reach through region 22, and the elimination of the N+ region in the epi 50 beneath the drain area. In place of the N+ region beneath the drain, the present invention utilizes a low barrier Schottky Barrier Diode (SBD) 80 at the drain opening 66 in contact with the N⁻ epi 5. A metal line 82 is evaporated over the SBD to form the drain contact. The low barrier Schottky Diode is formed using titanium, tungsten, an alloy of titanium and tungsten, chromium, tantalum or other metals having a barrier height on N⁻ type silicon of less than about 0.55 electron volt.

Metallization of source, injector and drain coupling common points in an array is accomplished using known techniques. The metal line coupling source region runs in the X-direction while injector and drain lines run orthogonal, in the Y-direction. A stud or raised portion of source terminals typically provided the height differential to allow the lines to cross without contact, it being understood that an insulator would also be employed between metallization layers.

As shown in Figure 1, ohmic contact is made to the source and injector regions. However, a Schottky contact is made to the drain region by means of SBD 80. Additionally, the heavily doped N+ region 22 separates trapped charges in the N⁻ epi 40 from the depletion region 51 of the Schottky contact. The region 22 prevents the SBD 80 from removing stored charge in the N⁻ epi 40. This structure eliminates the requirement for an external diode for each cell when forming a two-dimensional array.

Fig. 2 shows the equivalent circuit of a single cell, defining a unijunction transistor. The operation of the equivalent circuit in Figure 2 as a function of charge and current flow in the Figure 1 single cell will now be described with respect to the operation of the composite memory forming a two-dimensional array.

Figure 3 shows a sample memory array comprising four unijunction transistor elements each comprising a single memory cell. The array is denoted utilizing conventional identifying formats with the horizontal lines denoted by the first digit and the vertical columns denoted by the second digit. Accordingly, the cell 11 is the first cell in the first column of the first row. Cell 12 is the second cell in the first row while cell 21 is the first cell in the second row. In actual practice a typical array will be much larger, for example 64K bits.

The operation of the single cell shown in Figure 1 is similar to that described in the above-referenced co-pending application. If the P+ injector region 72 and the N+ source region 68 are held at ground potential, and the Schottky Barrier Diode 80 is forward biased with respect to the source, a small current will flow between the source and drain due to the high resistance in the N⁻ region 40. If the P+ injector region 72 is forward biased with respect to the source region 68, holes are injected from the P+ region 72 to the N⁻ epi 40. however, the existence of the N+ reach through region 22 prevents the loss of such stored charge. Two high-low junctions exist at the interface between N+ region 68 and N⁻ epi 40, and N+ region 70 and the N− epi 40. A third high-low junction exists between the N+ region 20 and the N⁻ region 40. The electric field existing at those junctions tends to oppose hole movement into the N+ regions. Therefore, the injected holes from the injector region 72 will be stored in the N⁻ epi 40.

If the P+ injector region 72 is held at ground potential and the drain region 80 having the low barrier SBD is biased with respect to the source 68, also held at ground potential, the low barrier Schottky will not inject minority carriers. However, due to the bias which exists between the SBD and the source 68, a large current will initially flow from between the source region 68 and the drain region 80 due to holes stored in the N− epi 40. As the current flows through the device, the stored charge is removed, the resistance becomes high and the current decays to a low level. The increase in current is sensed so that the presence or absence of stored holes in the N⁻ region can be used to determine binary one or binary zero values for a memory cell.

Consider now the operation of the array of Figure 3. Initially, lines $y_1$ and $y_2$ are held at a low level v1 shown in the timing diagram of Figure 4. Lines $x_1$ and $x_2$ are initially held at the high level (v2). The Schottky Barrier Diodes (SBD) for the cell have a zero applied bias since v2 is applied to both sides of the SBD. Accordingly, there is no current flow and the outputs $O_1$ and $O_2$ are at the same high level, v2. This is shown in Figure 4 at point 1. The variable resistor values of each of the cells are therefore either at the high state, that is, no charge stored, or at a low state, where minority carrier charges have been stored.

The cycle begins with a read operation shown as point 2 in Figure 4. The operation will be discussed for devices 21 and 22 since simultaneous read out occurs. Line $x_2$ falls to a low potential (v1) and current flows into devices 21 and 22 but not into devices 11 and 12 since $x_1$ is at the high level v2. The magnitude of the current is determined by the charge stored in devices 21 and 22 in the previous cycle. If no charge has been stored in device 21, the current has a low value and the output $O_1$ falls by a small amount as indicated by the dotted line in Figure 4. Also, $O_2$ falls by a small amount if no charge had been stored in device 22.

If a charge has been stored in device 21 or 22 a larger current will flow and the output $O_1$ or $O_2$

falls to a lower level indicated by the solid line in Figure 4. As the current flows through device 21 or 22, the stored charge is removed, the resistance increases and the current decays to a low value. The output rises to the level shown by the dotted line. A sense amplifier, not shown, is connected to output lines $O_1$ and $O_2$ to distinguish between the solid and dotted line waveforms of that output. Because the read operation as described removes stored charge, it becomes necessary to rewrite stored charge if such has been sensed. It is apparent that the read operation occurs simultaneously for device 22.

To write stored charge into device 21, line $y_1$ is raised to the high level (v2) as shown at point 3 in Figure 4. This high level v2 is shown as the solid line for $y_1$ in Figure 4. This is accomplished if charge has been sensed in the subsequent read operation and if it is desired to restore the old data. Accordingly, if restoration is desired, and if the old data was not a stored charge, then, line $y_1$ is held at the low level (v1). If new data is to be written, independent of any old data, $y_1$ is raised to the level v2 to store charge or held at level v1 for no stored charge to take place. Device 22 is written simultaneously with device 21 but independently under the control of line $y_2$.

Cells 11 and 12 are not disturbed during the read or write operations on devices 21 and 22 because the Schottky Barrier Diodes for those cells have not been forward biased, since $x_1$ was held at the high level v2 during the read and write operations described above. Devices 11 and 12 are selected for read and write operations by lowering the voltage of line $x_1$ while holding line $x_2$ at a high value.

While the operation of the memory array shown in Figure 3 has been explained in terms of four memory cells arranged in a 2 × 2 matrix, it is apparent that for practical applications, a much larger array, typically 64K bits, of devices (N × N) by a 256 × 256 array of devices would be employed to store N × N bits. Also, the array need not be symm. For example, 256 × 512 (N × M) array can be used to form a 128K bit memory. The essential operation would, however, be identical.

It is apparent, therefore, from this description that the N+ reach through region 22 functions to separate the N⁻ epi into two discrete regions 40 and 50 for the purpose of containing the stored charge within the region 40. This prevents the loss of stored charge during the data retention period and without N+ barrier 22 a loss would occur because of diffusion of minority carriers to the depletion region of the Schottky Barrier Diode. The present invention offers a significant improvement over the prior art by the elimination of the discrete external diode for each cell by the replacement of a SBD contact depletion region.

It is apparent that modifications and variations of this invention may be practiced without departing from the essential scope of this invention. For example, the injector and source regions may be reversed. The resistivity of region 50 could be altered by different dopings to increase its conductivity. This would be accomplished by ion implantation.

Reach through region 22 can be replaced by a recessed oxide (ROI) or other insulator so long as the N+ region 20 retains its continuity.

## Claims

1. A dynamic semiconductor memory cell comprising:
a substrate (10);
a first layer (20) of one conductivity type formed on said substrate (10);
a second layer (40, 50) of said one conductivity type formed on said first layer, said second layer lightly doped with respect to said first layer;
means (22) to divide said second layer into two separated areas (40 and 50);
an injector region (72) formed on the surface of said second layer in one of said separated areas (40) of a doped opposite conductivity type, said injection region (72) including a heavily doped zone (70) of said one conductivity type surrounding said opposite conductivity type region (72) within said second layer;
a source region (88) formed in said one of said two separated areas (40) containing said injector region (72); and
a drain region (51) formed in the other of said separated areas (50) by a low barrier Schottky contact (80) with said second layer.

2. A dynamic storage device using memory cells as claimed in claim 1, characterized by deep dielectric isolation regions (30) formed through said first and second layers (20, 40, 50) and extending to said substrate (10) defining a plurality of memory cell areas,
and metal lines coupling respective regions in said one memory cell area to respective regions in a second memory cell area.

3. The apparatus of claims 1 or 2, characterized in that said means to divide said second layer (40, 50) comprises a heavily doped region (22) of said one conductivity type extending from the surface of said second layer to said first layer.

4. The apparatus of claims 1 or 2, characterized in that said means to divide said second layer comprises a recessed oxide insulator extending from the surface of said second layer to said first layer.

5. The apparatus as claimed in any one of the claims 1 to 4, characterized in that said low barrier Schottky contact (80) comprises a metal contact selected from the group consisting of titanium, tungsten, an alloy of titanium and tungsten, chromium, tantalum or other metals having a barrier height on $N^-$ type silicon of less than about 0.55 electron volt.

6. The apparatus as claimed in any one of the claims 1 to 5, characterized in that said one conductivity type is N type silicon.

7. The apparatus as claimed in any one of the claims 1 to 6, characterized by comprising an insulating oxide coating (60) over said second layer.

8. The apparatus as claimed in any one of the claims 1 to 7, characterized in that said injector region comprised a boron P+ implant (72) surrounded by a heavily doped N+ silicon zone (70).

9. The apparatus as claimed in any one of the claims 1 to 8, characterized in that the resistivity of said separated areas (40, 50) is different.

10. The apparatus as claimed in any one of the claims 1 to 9, characterized in that said injector region (72) is positioned between said source (68) and drain regions (51).

## Patentansprüche

1. Dynamische Halbleiterzelle, folgendes enthaltend:
ein Substrat (10);
eine erste Schicht (20) eines Leitfähigkeitstyps auf dem Substrat (10);
eine zweite Schicht (40, 50) dieses Leitfähigkeitstyps auf der ersten Schicht, wobei die zweite Schicht leicht in bezug auf die erste Schicht dotiert ist;
Mittel (22) zur Teilung der zweiten Schicht in zwei getrennte Bereiche (40 und 50);
einen Injektorbereich (72) auf der Oberfläche der zweiten Schicht in einem der getrennten Bereiche (40) eines dotierten entgegengesetzten Leitfähigkeitstyps, wobei der Injektorbereich (72) eine stark dotierte Zone (70) des einen Leitfähigkeitstyps um den Bereich (72) des entgegengesetzten Leitfähigkeitstyps innerhalb der zweiten Schicht umfaßt;
einen Source-Bereich (68) in dem einen der zwei getrennten Bereiche (40) mit dem Injektorbereich (72), sowie
einen Drain-Bereich (51) in dem anderen der beiden getrennten Bereiche (50) durch einen Schottky-Kontakt niedriger Barriere (80) mit der zweiten Schicht.

2. Dynamische Speichervorrichtung mit Speicherzellen nach Anspruch 1,
gekennzeichnet durch
tiefe dielektrische Isolationsbereiche (30), welche sich durch die ersten und zweiten Schichten (20, 40, 50) zum Substrat (10) erstrecken und eine Vielzahl von Speicherzellenbereichen definieren,
sowie durch Metalleitungen, welche die jeweiligen Bereiche im einen Speicherzellenbereich mit entsprechenden Bereichen in einem zweiten Speicherzellenbereich verbinden.

3. Anordnung gemäß den Ansprüchen 1 oder 2, dadurch gekennzeichnet, daß die Mittel zur Teilung der zweiten Schicht (40, 50) einen stark dotierten Bereich (22) des einen Leitfähigkeitstyps umfassen, welcher sich von der Oberfläche der zweiten Schicht zur ersten Schicht erstreckt.

4. Vorrichtung nach Anspruch 1 oder 2, dadurch gekennzeichnet, daß die Mittel zur Trennung der zweiten Schicht einen abgesenkten Oxydisolator enthalten, welcher sich von der Oberfläche der zweiten Schicht zur ersten Schicht erstreckt.

5. Vorrichtung nach einem der Ansprüche 1 bis 4, dadurch gekennzeichnet, daß der Schottky-Kontakt (80) niedriger Barriere einen Metallkontakt aus der Gruppe von Titan, Wolfram, einer Titan-Wolfram-Legierung, Chrom, Tantal oder anderen Metallen mit einer Sperrhöhe von N⁻ Silicium von weniger als ca. 0,55 Elektron-Volt enthält.

6. Vorrichtung nach einem der Ansprüche 1 bis 5, dadurch gekennzeichnet, daß es sich bei dem einen Leitfähigkeitstyp um N-Silicium handelt.

7. Vorrichtung nach einem der Ansprüche 1 bis 6, dadurch gekennzeichnet, daß sie eine Isolationsbeschichtung (60) über der zweiten Schicht aufweist.

8. Vorrichtung nach einem der Ansprüche 1 bis 7, dadurch gekennzeichnet, daß der Injektorbereich ein Bor-P+ Implantat (72) aufweist, welches von einem stark dotierten N+ Siliciumbereich (70) umgeben ist.

9. Vorrichtung nach einem der Ansprüche 1 bis 8, dadurch gekennzeichnet, daß der spezifische Widerstand der getrennten Bereiche (40, 50) unterschiedlich ist.

10. Vorrichtung nach einem der Ansprüche 1 bis 9, dadurch gekennzeichnet, daß der Injektorbereich (72) zwischen den Source- (68) und Drain-Bereichen (51) vorgesehen ist.

**Revendications**

1. Cellule de mémoire dynamique à semiconducteurs comprenant:
— un substrat (10);
— une première couche (20) d'un certain type de conductivité formée sur ledit substrat (10);
— une seconde couche (40, 50) dudit type de conductivité formée sur ladite première couche, ladite seconde couche étant légèrement dopée par rapport à ladite première couche;
— un moyen pour diviser ladite seconde couche en deux zones séparées (40 et 50);
— une région d'injecteur (72) formée sur la surface de ladite seconde couche dans une desdites zones séparées (40) d'un type dopé de conductivité opposée, ladite région d'injecteur (72) comprenant une zone (70) fortement dopée du type de conductivité cité en premier, entourant ladite région du type de conductivité opposé (72) à l'intérieur de ladite seconde couche;
— une région de source (68) formée dans la première des deux zones séparées précitées (40) contenant ladite région d'injecteur (72); et
— une région de drain (51) formée dans l'autre zone séparée (50) par un contact à faible barrière de Schottky (80) avec ladite seconde couche.

2. Un dispositif de mémoire dynamique utilisant des cellules de mémoire telles que revendiquées dans la revendication 1, caractérisé par:
— des régions profondes d'isolation diélectrique (30) formées au travers desdites première et seconde couches (20, 40, 50) et s'étendant jusqu'audit substrat (10) en définissant une pluralité de zones de cellules de mémoire;
— et des lignes métalliques reliant des régions respectives situées dans ladite zone de cellule de mémoire avec des régions respectives situées dans une seconde zone de cellule de mémoire.

3. Le dispositif des revendications 1 ou 2, caractérisé en ce que ledit moyen de division de ladite seconde couche (40, 50) comprend une région fortement dopée (22) du type de conductivité cité en premier, s'étendant de la surface de ladite seconde couche jusqu'à ladite première couche.

4. Le dispositif des revendications 1 ou 2, caractérisé en ce que ledit moyen de division de ladite seconde couche comprend un isolateur à oxyde en creux s'étendant de la surface de ladite seconde couche jusqu'à ladite première couche.

5. Le dispositif tel que revendiqué dans une quelconque des revendications 1 à 4, caractérisé en ce que ledit contact à faible barrière de Schottky (80) comprend un contact métallique choisi dans le groupe comprenant le titane, le tungstène, un alliage de titane et de tungstène, le chrome, le tantale et d'autres métaux ayant une hauteur de potentiel de barrière par rapport au silicium de type N⁻ inférieure à environ 0,55 électron-volt.

6. Le dispositif tel que revendiqué dans une quelconque des revendications 1 à 5, caractérisé en ce que ledit type de conductivité cité en premier correspond à du silicium de type N.

7. Le dispositif tel que revendiqué dans une quelconque des revendications 1 à 6, caractérisé en ce qu'il comprend un revêtement d'oxyde isolant (60) placé sur ladite seconde couche.

8. Le dispositif tel que revendiqué dans une quelconque des revendications 1 à 7, caractérisé en ce que ladite région d'injecteur comprend un implant de bore P+ (72) entouré par une zone de silicium N+ fortement dopé (70).

9. Le dispositif tel que revendiqué dans une quelconque des revendications 1 à 8, caractérisé en ce que la résistivité desdites zones séparées (40, 50) est différente.

10. Le dispositif tel que revendiqué dans une quelconque des revendications 1 à 9, caractérisé en ce que ladite région d'injecteur (72) est disposée entre lesdites régions de source (68) et de drain (51).

FIG.1

FIG.2

SOURCE

INJECTOR

SBD

DRAIN

80

FIG.3

FIG.4

READ    WRITE